# EUROPEAN PATENT SPECIFICATION

(11) **EP 1 421 837 B1**
(45) Date of publication and mention of the grant of the patent: **04.05.2011**
(21) Application number: 02780260.2
(22) Date of filing: 09.08.2002
(51) Int. Cl.: H05K 7/20

(54) **ELECTRICALLY ISOLATED MODULE**
ELEKTRISCH ISOLIERTES MODUL
MODULE A ISOLATION ELECTRIQUE

(30) Priority: 10.08.2001 US 927418
(43) Date of publication of application: 26.05.2004
(73) Proprietor: Black & Decker Inc., Newark, DE 19711 (US)
(72) Inventor: PRIVETT, Zollie, W., Baltimore, MD 21206 (US); CROWELL, Brian, R., Newark, PA 17402 (US)
(74) Representative: Bell, Ian Stephen
(86) International application number: PCT/US2002/025547
(87) International publication number: WO 2003/017742

(56) References cited:
- GB-A- 2 190 795
- US-A- 5 321 582
- US-A- 5 766 985
- US-A- 5 909 358
- US-A- 5 926 373

## Description

### BACKGROUND OF THE INVENTION

### Technical Field

The present invention generally relates to electrically isolated control modules. More particularly, the invention relates to an electrically isolated control module having dual insulation layers between an internal line voltage and an external heat sink.

### Discussion

Electronic devices operating on relatively high AC line voltages have existed for years. Power tools such as miter saws, belt sanders, and household appliances are but a few examples of these types of devices. The typical power tool has a voltage system providing the line voltage for the tool (based on a commercial AC source) and a tool housing enclosing the system. Control modules (such as a speed controller) are often connected to the line voltage and are also disposed within the tool housing. Thus, in the case of a miter saw, the speed controller may control the rotational speed of the saw blade based on the line voltage and one or more switching signals. In order to avoid electric shock to individuals touching the outside of the tool housing, such a controller is typically embedded into an internal enclosure and positioned far enough away from the tool housing to provide the desired amount of electrical isolation between the tool housing and the line voltage.

While the above-described approach to electrically isolating a control module is acceptable under some circumstances, certain difficulties remain. For example, as the size of power tools and the amount of available airflow within the tool decreases, the flexibility in positioning the module within the tool also decreases. This fact is particularly troublesome considering the exacting requirements of modern day safety standards. For example, Underwriters Laboratories (UL) requires a minimum of 3700 volts of isolation between the AC line voltage and any user-accessible (or user-graspable) housing of a tool or appliance. Design engineers are encountering considerable difficulty in meeting this requirement given the creepage and clearance constraints dictated by these safety standards. It is therefore desirable to provide an electrically isolated module that is highly flexible with respect to module placement in relation to user-accessible housings.

### SUMMARY OF THE INVENTION

The above and other objectives are provided by a power tool in accordance with the principles of the present invention. The tool has a voltage system providing a line voltage for the tool and a user-graspable tool housing enclosing the voltage system. A double insulated (DI) control module is connected to the line voltage and mechanically coupled to an interior tool housing surface such that the metal tool housing itself functions as a heat sink for the control module. By mechanically coupling the control module to an interior tool housing surface, flexibility in the interior design of the tool as well as control module placement within the tool housing is significantly increased.

Further in accordance with the present invention, an electronic module is provided. The module includes a power device and a thermal pad. The power device is connected to a line voltage, where the power device provides a first layer of electrical insulation between the line voltage and an external tab of the power device. The thermal pad is disposed between the external tab and a heat sink. The thermal pad provides a second layer of electrical insulation between the external tab and the heat sink. Thus, the first and second layers combine to provide a predetermined minimum amount of electrical insulation between the line voltage and the heat sink.

In another aspect of the invention, a method for isolating a line voltage from a heat sink is provided. The method includes the steps of electrically connecting a power device to the line voltage, and providing a first layer of electrical insulation between the line voltage and an external tab of the power device. The method further provides for positioning a thermal pad between the heat sink and tool housing such that the thermal pad provides a second layer of electrical insulation between the heat sink and tool housing. Isolation is therefore provided by the combination of the first and second layers.

It is to be understood that both the foregoing general description and the following detailed description are merely exemplary of the invention, and are intended to provide an overview or framework for understanding the nature and character of the invention as it is claimed. The accompanying drawings are included to provide a further understanding of the invention, and are incorporated in and constitute part of this specification. The drawings illustrate various features and embodiments of the invention, and together with the description serve to explain the principles and operation of the invention.

### BRIEF DESCRIPTION OF THE DRAWINGS

The various advantages of the present invention will become apparent to one skilled in the art by reading the following specification and sub joined claims and by referencing the following drawings, in which:
Figure 1 is a perspective view of a power tool with a user-accessible tool housing in accordance with the principles of the present invention;
Figure 2 is a perspective view of a power tool housing showing a representative control module location in accordance with the principles of the present invention;
Figure 3 is a perspective view of a power tool housing cavity showing a control module in accordance with the principles of the present invention;
Figure 4 is a perspective view of an electronic control module in accordance with the principles of the present invention;
Figure 5 is a plan view of the electronic control module shown in Figure 4;
Figure 6A is a section view of the control module taken along lines 6A-6A shown in Figure 5;
Figure 6B is a section view of the control module taken along lines 6B-6B shown in Figure 5;
Figure 6C is a section view of the control module taken along lines 6C-6C shown in Figure 5;
Figure 6D is a section view of the control module taken along lines 6D-6D shown in Figure 5; and
Figure 7 is a perspective view of an alternative embodiment of a control module mounted to an exterior of a power tool housing showing an external thermal pad.

### DETAILED DESCRIPTION OF THE PREFERRED EMBODIMENTS

The following description of the preferred embodiment(s) is merely exemplary in nature and is in no way intended to limit the invention, its application, or uses.

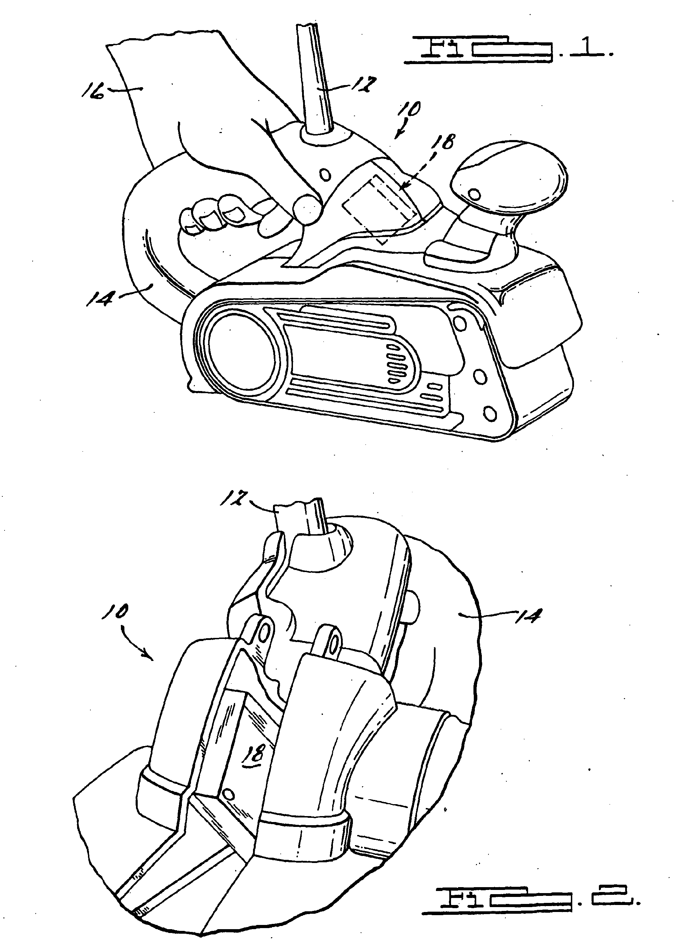

Turning now to Figure 1, a perspective view of an exemplary power tool 10 is shown. It should be noted that while the present invention will be primarily described with respect to power tools and appliances, the invention is not so limited. In fact, the principles described herein can improve the functionality of any electronic device in which electrical isolation is desired. Furthermore, the control module described below is only one type of electronic module that can benefit from the present invention. Thus, sensing modules, power supply modules, display modules and other electronic modules can be improved using the principles described herein. Notwithstanding, the following discussion will demonstrate that power tool control modules have a number of aspects for which the present invention is uniquely suited. Turning to the present invention, it can be seen that the power tool 10 has a power cord 12 for providing AC power to the tool 10, and a tool housing 14 that is accessible by a user 16. Tool housing 14 encloses a portion of the power cord 12 while the location of a control module 18 of the present invention is shown in phantom. It will be appreciated that the module 18 could be supported within the tool 10 at different locations within the tool. The illustration of the control module 18 as being within the handle portion therefore represents one suitable internal area of the tool 10 where the control module 18 could be located. The housing 18 may be entirely of a metallic material or some portions thereof may be made from other materials such as plastic.

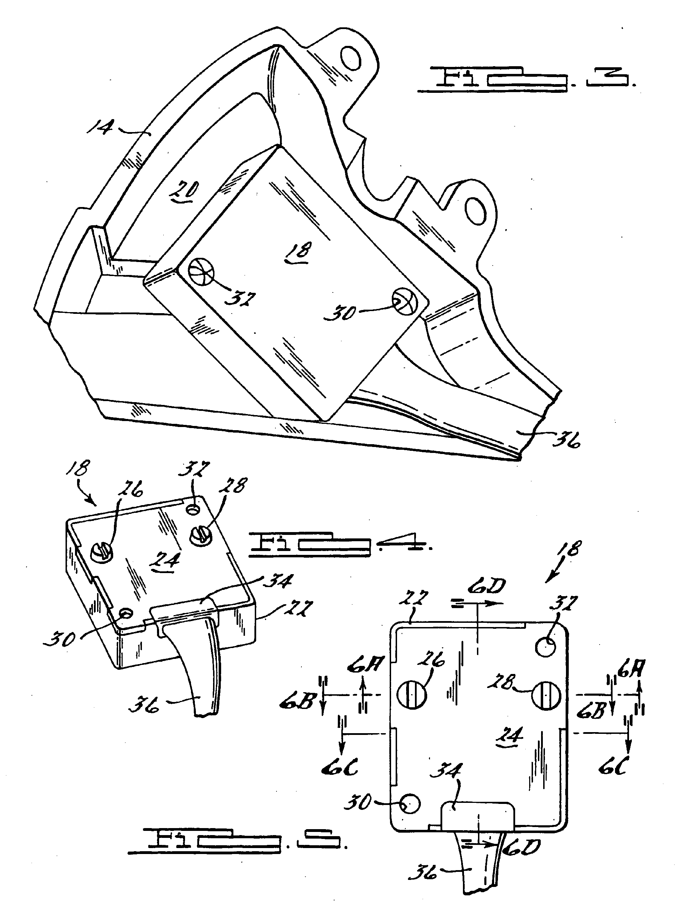

With additional reference to Figures 2 and 3, it is shown generally how the control module 18 connects to the power cord 12 and mechanically couples to an interior surface 20 of the tool housing 14 such that the tool housing 14 functions as a heat sink for the electronic control module 18. While the discussion herein will primarily refer to the specific use of the heat sink as a tool housing 14, it will be appreciated that the heat sink is not limited to such an application. Nevertheless, by coupling the control module 18 directly to the tool housing 14, significant space savings and flexibility in mounting the control module 18 are realized.

With continued reference to Figures 1-3, it is important to note that the power tool 10, being operated by a user 16, has various external surfaces that are accessible or touchable by the user 16 or which otherwise make user 16 contact. Furthermore, at least portions of the tool housing 14 are often made of a material that is electrically conductive, such as a metal alloy. Alternatively, an insulating material such as plastic comprises the tool housing 14 or the exterior surface of the tool housing 14. Thus, the AC source supplying power to the power cord 12 to which the control module 18 is connected, must be electrically isolated from the tool housing 14 in order for a user 16 to avoid electrical shock.

Turning now to Figures 4 and 5, the electronic control module 18 is shown in greater detail. The control module 18 has a housing 22 forming a container with a heat sink cover 24 secured to the module housing 22 by screws 26 and 28. The control module 18 is secured to a mounting surface, such as interior surface 20 of tool housing 14 as shown in Figure 3, by fastening members which extend through holes 30 and 32. Alternatively, the control module 18 may be secured to a mounting surface by an adhesive. The heat sink cover 24 and module housing 22 provide a gap 34 for a wiring harness 36 to pass and be operatively coupled to the power cord 12. Furthermore, the module housing 22 encloses a circuit board, power device and thermal pad (to be described below).

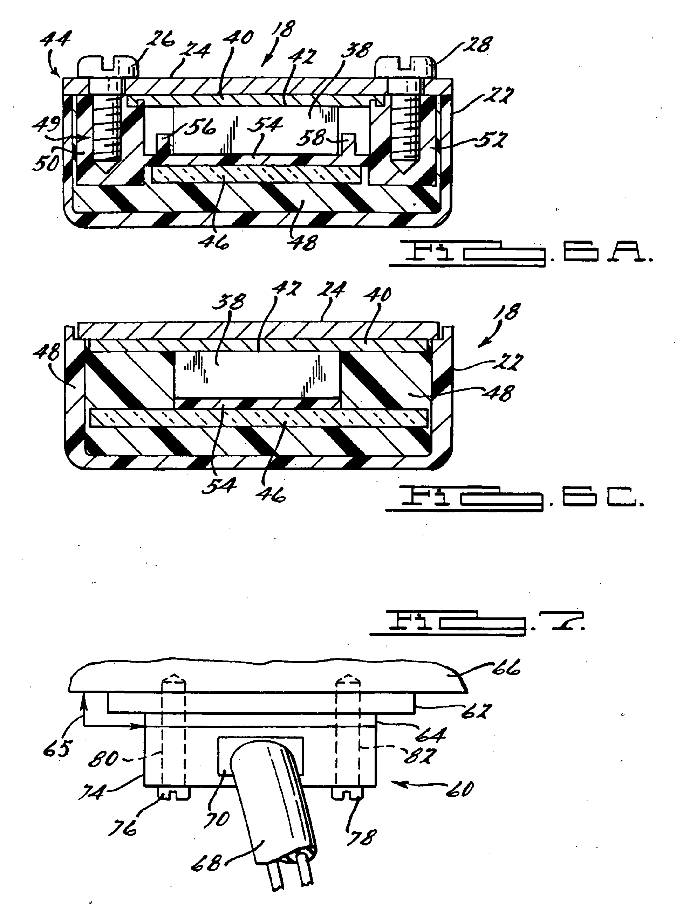

With reference to Figures 6A-6D, the structure of the control module 18 will be explained in greater detail. Specifically, it can be seen that the control module 18 includes a power device 38 and a thermal pad 40. The power device 38 is preferably an isolated-tab thyristor and is electrically connected to an AC voltage source. By selecting the power device 38 to be an isolated-tab power device, an external tab 42 of the power device 38 is electrically isolated from the AC voltage source. Isolated-tab thyristors are commercially available and commonly provide a minimum breakdown voltage of 2700 volts. Thus, the power device 38 provides a first layer of electrical insulation between the line voltage and the external tab 42.

The thermal pad 40 is disposed between the external tab 42 and the heat sink cover 24. The thermal pad 40 provides a second layer of electrical insulation between the external tab 42 and the heat sink cover 24. Thus, the power device 38 and thermal pad 40 combine to provide a predetermined amount of electrical insulation between the AC source and the tool housing 14 (Figure 1). This double layer of insulation enables a user 16 to contact all external surfaces of the tool housing 14 without fear or risk of electrical shock. Additionally, this double layer of insulation meets TUV and UL requirements with respect to insulation and control module 18 spacing requirements from a user contact surface.

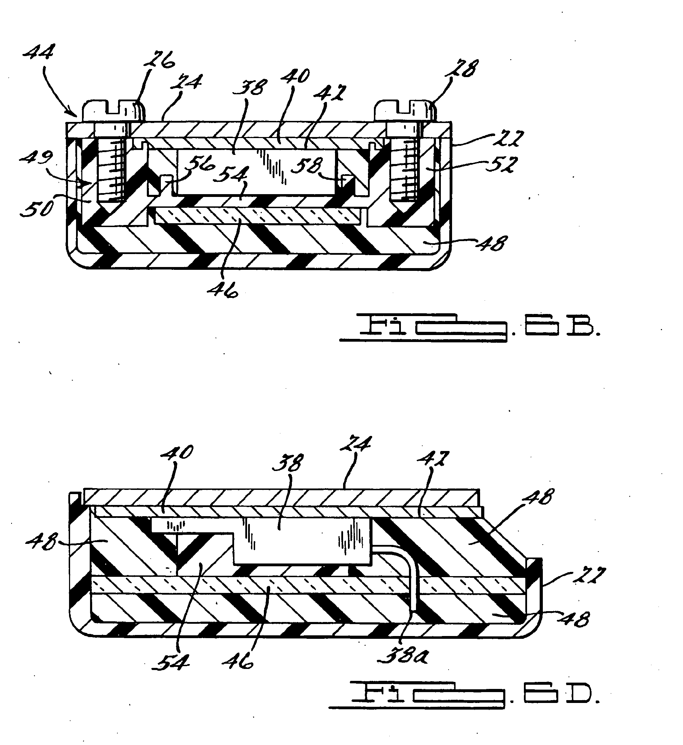

With regard to the thermal pad 40 of Figure 6A and 6B, it will be appreciated that a connection mechanism 44 is coupled to the module housing 22. The connection mechanism is formed by screws 26 and 28 and a support component 49. The support component 49 is formed by a first post 50, a second post 52 and a bridge 54 extending between the posts 50 and 52. The connection mechanism 44 functions to compress the thermal pad 40 to a controlled minimum thickness of about 1.0 mm. One such thermal pad 40, for example, is available from Fuji Polymer Industries of Japan under the trade name Sarcon®. This material provides a minimum of approximately 2000 volts of electrical insulation and is compressed to a thickness of approximately 1.1 mm. This 1.1 mm thickness meets the mechanical UL requirement for isolation. Considerations in selecting the thermal pad 40 include strength of the material, softness, thermal conductivity, and electrical conductivity.

With reference to Figures 5-6D, it will be appreciated that a wiring harness 36 couples the AC line voltage from the power cord 12 to the control module 18. The circuit board 46 is coupled to the power device 38 and to the wiring harness 36. The circuit board 46 contains conductors for coupling the AC line voltage to the power device 38. As already mentioned, the control module 18 includes a module housing 22 coupled to the tool housing 14, where the module housing 22 encloses the circuit board 46, the power device 38 and the thermal pad 40. A potting compound 48 is disposed within the module housing 22 to provide required further isolation, structural support, and environmental protection. Acceptable potting compounds are commercially available from a number of well known sources.

Continuing with reference to Figures 6A and 6B, a method of connection of the control module 18 will now be explained. The preferred connection mechanism 44 includes the support member 49 having the first post 50, contacting a first edge of the circuit board 46, and the first screw 26, coupled to the first post 50. The second post 52 contacts a second edge of the circuit board 46, while the second screw 28 couples to the second post 52. It can also be seen that the bridge 54 includes wall portion 56 and portion 58 which cooperatively form a receptacle for nesting the power device 38 therein. The bridge 54 is also responsible for maintaining the required thickness of the thermal pad 40 between the external tab 42 and the heat sink cover 24, enhancing the mechanical support provided to the power device 38, and maintaining isolation between screws 26 and 28 and the AC line voltage. The support member 49 is preferably made of plastic, and preferably formed as a single integral formed component.

Assembling the control module 18 of the present invention entails soldering the power device 38 to the circuit board 46 including bending an electrical lead of the power device 38 into a generally "L" shaped configuration 38a that extends into and through the circuit board 46 and into the potting compound 48 as shown in Figure 6D. The bridge 54 is disposed between the power device 38 and the circuit board 46. The thermal pad 40 is then applied to the heat sink cover 24, and the thermal pad 40 and heat sink cover 24 assembly is coupled to the circuit board 46 and associated bridge 54, via the connection mechanism 44 shown in Figures 6A and 6B. Upon securing screws 26 and 28, the circuit board 46, connection mechanism 44, and thermal pad 40 assembly is disposed within the module housing 22 and then potted with the potting compound 48.

Turning now to Figure 7, an alternative embodiment of a control module 60 in accordance with the present invention is shown. The control module 60 includes a thermal pad 62 interposed between a module heat sink cover 64 and a tool housing 66. The thermal pad 62 is preferably approximately 1.2 mm thick and provides the additional insulation necessary to surpass current DI standards for Europe and the United States. A wiring harness 68 extends through an aperture 70 defined by a housing surface 72 of a module housing 74. Screws 76 and 78 extend through holes 80 and 82, respectively, for attachment of the module housing 74 to the tool housing 66. Also, a creepage and clearance distance/path between the tool housing 66 and the heat sink cover 64, in accordance with arrow 65, needs to be provided of about 4 mm.

Through the configuration of Figure 7, the tool housing 66 is usable as a heat sink for the control module 60 without risk of electrical shock if user contact is made with tool housing 66. Unlike the embodiment of Figures 1-6D, the control module 60 of the Figure 7 embodiment does not possess a thermal pad 40 enclosed within the control module 18, as shown in Figures 6A-6D. Alternatively, control module 60 exemplifies an external thermal pad 62 approach to a dual insulation layer concept. It should also be noted that wiring harness 68 must meet applicable UL insulation requirements.

An electronic control module 18 is therefore provided that offers a dual insulation arrangement between the power cord 12 and the tool housing 14 that also serves as a heat sink thereby allowing versatility in mounting the electronic control module 18 to the interior surface 20 and also eliminating the risk of electrical shock to a user 16 making contact with the tool housing 14. Additionally, the double insulated control module 18 provided meets or exceeds TUV and UL standards for its application within a tool housing 14.

Those skilled in the art can now appreciate from the foregoing description that the broad teachings of the present invention can be implemented in a variety of forms. Therefore, while this invention can be described in connection with particular examples thereof, the true scope of the invention should not be so limited since other modifications will become apparent to the skilled practitioner upon a study of the drawings, specification and following claims.

## Claims

1. An electronic module adapted to be disposed within a housing (22) of an AC powered power tool and to make use of a portion of the housing as a heat sink, the module comprising:
a power device (38) having an external tab (42) and being coupled to a line
voltage source said power device providing a first layer of electrical insulation between the line voltage source and the external tab of the power device; and
a thermal pad (40) disposed between the external tab and the housing, the thermal pad providing a second layer of electrical insulation between the external tab and the housing;
said first and second layers combining to provide a predetermined minimum amount of electrical insulation between the line voltage source and the housing while enabling said housing to function as a heat sink to dissipate heat developed by said power device.

2. The electronic module of claim 1 further comprising a bridge support, said bridge support further comprising a first wall and a second wall to form a receptacle to receive said power device therewithin.

3. The bridge support of claim 2 wherein said bridge support further comprising a first post and a second post, said first post and said second post being spaced apart from one another and used for securing said power device within said module.

4. The electronic module of claim 1 further comprising a circuit board, said circuit board being fixedly coupled to said power device.

5. The electronic module of claim 4, wherein said module comprises a module housing, and a layer of potting compound disposed within said module housing to support the circuit board on said layer within said module housing.

6. The potting compound of claim 5 wherein said potting compound is placed within said module housing to fill voids within said module housing after said electronic module assembly is fully assembled.

7. An AC powered power tool having an electronic control module disposed within a tool housing (22) of the power tool, the tool housing acting as a
heat sink for the electronic control module, the power tool comprising:
a line voltage passing through said tool housing and connecting to the electronic control module which nests within the tool housing, said electronic control module comprising:
a power device (38) said power device connecting to said line voltage and providing a first layer of electrical insulation between said line voltage and a external tab (42) of said power device; and
a thermal pad (40) wherein said thermal pad is disposed between said external tab and a control module cover, said thermal pad providing a second layer of electrical insulation between said external tab and said cover and providing a predetermined minimum amount of electrical insulation between said line voltage and said tool housing to prevent electrical shock to a user contacting an external surface of said tool housing wherein said tool housing and said control module cover also act as heat sinks to dissipate heat developed by said power device.

8. The control module of claim 7 further comprising a connection mechanism comprising:
a first post on a first side of said power device;
a second post on a second side of said power device;
a bridge portion connecting said first post and said second post, said posts containing threads and securing a first screw and a second screw, respectively.

9. The control module of claim 8 wherein said bridge portion of said connection mechanism holds said power device and said thermal pad against said control module cover when said first screw and said second screw are tightened.

10. The thermal pad of claim 9 wherein said thermal pad is compressed to a minimum thickness of 1 mm.

11. The power tool of claim 7 further comprising a power tool wall, said power tool wall further comprising an inside surface and an outside surface, said power tool wall acting as a heat sink for said control module for heat radiated by said control module when said control module is attached to said inside surface of said power tool wall.

12. The power tool of claim 7 further comprising a circuit board, said circuit board contacting said power device within said control module.

13. The power tool of claim 12 further comprising a potting compound, said potting compound providing a foundation to secure said circuit board within said control module.

14. An electrically isolated, double insulated electronic control module for use in a power tool, the electronic control module comprising:
a module housing (22) said module housing having four walls, a bottom portion connected to said four walls at one end of said four walls, said four walls having an end opposite said bottom portion thereby defining an opening;
a cover that covers said opening of said module housing;
a power device (38) having a first side and a second side, said power device second side facing said cover, said power device first side situated on a first side of a bridge portion (54), said bridge portion further comprising:
a first wall and a second wall to form a receptacle to receive said power device therewithin, a first post and a second post, said first post and said second post each linking to said cover by a first fastener and a second fastener, respectively;
a thermal pad (40) having a first side and a second side, said first side situated against said cover and said second side situated against said second side of said power device, said first fastener and said second fastener holding said bridge portion, said power device, and said thermal pad against said module housing cover; and
a circuit board (46) having a first side and a second side, said first side of said circuit board situated against a second side of said bridge portion, and said second side of said circuit board situated against a layer of potting compound which rests upon said bottom portion of said module housing.

15. An electrically isolated, double insulated electronic control module for use in a power tool housing, the electronic control module comprising:
a module housing (22) said module housing having four walls, a bottom portion connected to said four walls at one end of said four walls, said four walls having an end opposite said bottom portion thereby defining an opening;
a cover that covers said opening of said module housing;
a power device (38) having a first side and a second side, said power device second side facing said cover, said power device first side situated on a first side of a bridge portion (54), said bridge portion further comprising:
a first wall and a second wall to form a receptacle to receive said power device therewithin, a first post and a second post, said first post and said second post each linking to said cover by a first fastener and a second fastener, respectively;
a thermal pad (40) having a first side and a second side, said first side situated against said cover and said second side situated against the power tool housing, said first fastener and said second fastener holding said bridge portion and said power device against said module housing cover; and
a circuit board (46) having a first side and a second side, said first side of said circuit board situated against a second side of said bridge portion, and said second side of said circuit board situated against a layer of potting compound which rests upon said bottom portion of said module housing.

## Patentansprüche

1. Elektronisches Modul, angepasst, um in einem Gehäuse (22) eines wechselstrombetriebenen Elektrowerkzeugs angebracht zu werden, und um einen Abschnitt des Gehäuses als Wärmeableitvorrichtung zu verwenden, wobei das Modul Folgendes umfasst:
eine Stromversorgungsvorrichtung (38), die einen äußeren Streifen (42) aufweist und mit einer Netzspannungsquelle gekoppelt ist, wobei die Stromversorgungsvorrichtung eine erste Schicht elektrischer Isolierung zwischen der Netzspannungsquelle und dem äußeren Streifen der Stromversorgungsvorrichtung aufweist; und
ein Thermokissen (40), angebracht zwischen dem äußeren Streifen und dem Gehäuse, wobei das Thermokissen eine zweite Schicht elektrischer Isolierung zwischen dem äußeren Streifen und dem Gehäuse bereitstellt;
wobei sich die erste und die zweite Schicht verbinden, um eine vorbestimmte minimale Menge elektrischer Isolierung zwischen der Netzspannungsquelle und dem Gehäuse bereitzustellen, während dem Gehäuse ermöglicht wird, wie eine Wärmeableitvorrichtung zu funktionieren, um die Wärme abzuleiten, die von der Stromversorgungsvorrichtung erzeugt wurde.

2. Elektronisches Modul nach Anspruch 1, weiter umfassend eine Brückenstütze, wobei die Brückenstütze weiter eine erste Wand und eine zweite Wand umfasst, um eine Aufnahme zu bilden, um darin die Stromversorgungsvorrichtung aufzunehmen.

3. Brückenstütze nach Anspruch 2, wobei die Brückenstütze weiter eine erste Säule und eine zweite Säule umfasst, wobei die erste Säule und die zweite Säule voneinander beabstandet sind und verwendet werden, um die Stromversorgungsvorrichtung in dem Modul zu sichern.

4. Elektronisches Modul nach Anspruch 1, weiter umfassend eine Leiterplatte, wobei die Leiterplatte fest mit der Stromversorgungsvorrichtung gekoppelt ist.

5. Elektronisches Modul nach Anspruch 4, wobei das Modul ein Modulgehäuse umfasst sowie eine Schicht aus Vergussmasse, angebracht in dem Modulgehäuse, um die Leiterplatte auf der Schicht in dem Modulgehäuse zu tragen.

6. Vergussmasse nach Anspruch 5, wobei die Vergussmasse in dem Modulgehäuse angebracht ist, um Hohlräume in dem Modulgehäuse auszufüllen, nachdem die elektrische Modulbaugruppe vollständig zusammengebaut ist.

7. Wechselstrombetriebenes Elektrowerkzeug, umfassend ein elektronisches Kontrollmodul, angebracht in einem Werkzeuggehäuse (22) des Elektrowerkzeugs, wobei das Werkzeuggehäuse als Wärmeableitvorrichtung für das elektronische Kontrollmodul dient, wobei das Elektrowerkzeug Folgendes umfasst:
eine Netzspannung, die durch das Werkzeuggehäuse verläuft und sich mit dem elektronischen Kontrollmodul verbindet, das im Werkzeuggehäuse eingeschlossen ist, wobei das elektronische Kontrollmodul Folgendes umfasst:
eine Stromversorgungsvorrichtung (38), wobei sich die Stromversorgungsvorrichtung mit der Netzspannung verbindet und eine erste Schicht elektrischer Isolierung zwischen der Netzspannung und einem äußeren Streifen (42) der Stromversorgungsvorrichtung bereitstellt; und
ein Thermokissen (40), wobei das Thermokissen zwischen dem äußeren Streifen und einer Kontrollmodulabdeckung angebracht ist, wobei das Thermokissen eine zweite Schicht elektrischer Isolierung zwischen dem äußeren Streifen und der Abdeckung bereitstellt und eine vorbestimmte minimale Menge elektrischer Isolierung zwischen der Netzspannung und dem Werkzeuggehäuse bereitstellt, um zu verhindern, dass ein Benutzer, der eine äußere Fläche des Werkzeuggehäuses berührt, einen elektrischen Schlag bekommt, wobei das Werkzeuggehäuse und die Kontrollmodulabdeckung auch als Wärmeableitvorrichtungen dienen, um Wärme abzuleiten, die von der Stromversorgungsvorrichtung entwickelt wird.

8. Kontrollmodul nach Anspruch 7, weiter umfassend einen Verbindungsmechanismus, umfassend:
eine erste Säule auf einer ersten Seite der Stromversorgungsvorrichtung;
eine zweite Säule auf einer zweiten Seite der Stromversorgungsvorrichtung;
einen Brückenabschnitt, der die erste Säule und die zweite Säule miteinander verbindet, wobei die Säulen Gewinde enthalten und eine erste Schraube bzw. eine zweite Schraube sichern.

9. Kontrollmodul nach Anspruch 8, wobei der Brückenabschnitt des Verbindungsmechanismus die Stromversorgungsvorrichtung und das Thermokissen gegen die Kontrollmodulabdeckung hält, wenn die erste Schraube und die zweite Schraube angezogen werden.

10. Thermokissen nach Anspruch 9, wobei das Thermokissen auf eine minimale Dicke von 1 mm komprimiert wird.

11. Elektrowerkzeug nach Anspruch 7, weiter umfassend eine Elektrowerkzeugwand, wobei die Elektrowerkzeugwand weiter eine innere Fläche und eine äußere Fläche umfasst, wobei die Elektrowerkzeugwand als eine Wärmeableitvorrichtung für das Kontrollmodul für Wärme dient, die 1 421 837 von dem Kontrollmodul abgestrahlt wird, wenn das Kontrollmodul an die Innenfläche der Elektrowerkzeugwand befestigt ist.

12. Elektrowerkzeug nach Anspruch 7, weiter umfassend eine Leiterplatte, wobei die Leiterplatte die Stromversorgungsvorrichtung in dem Kontrollmodul berührt.

13. Elektrowerkzeug nach Anspruch 12, weiter umfassend eine Vergussmasse, wobei die Vergussmasse ein Fundament bereitstellt, um die Leiterplatte in dem Kontrollmodul zu sichern.

14. Elektrisch isoliertes, doppelt gedämmtes elektronisches Kontrollmodul zur Verwendung in einem Elektrowerkzeug, wobei das elektronische Kontrollmodul Folgendes umfasst:
ein Modulgehäuse (22), wobei das Modulgehäuse vier Wände aufweist, einen Bodenabschnitt, der mit den vier Wänden an einem Ende der vier Wände verbunden ist, wobei die vier Wände ein Ende gegenüber dem Bodenabschnitt aufweisen und **dadurch** eine Öffnung definieren;
eine Abdeckung, die die Öffnung des Modulgehäuses abdeckt;
eine Stromversorgungsvorrichtung (38) mit einer ersten Seite und einer zweiten Seite, wobei die zweite Seite der Stromversorgungsvorrichtung der Abdeckung gegenüberliegt, wobei die erste Seite der Stromversorgungsvorrichtung auf einer ersten Seite eines Brückenabschnitts (54) angeordnet ist, wobei der Brückenabschnitt weiter umfasst:
eine erste Wand und eine zweite Wand, um einen Behälter zu bilden, um die Stromversorgungsvorrichtung darin aufzunehmen, eine erste Säule und eine zweite Säule, wobei sich die erste Säule und die zweite Säule jeweils durch eine erste Befestigung bzw. eine zweite Befestigung mit der Abdeckung verbinden;
ein Thermokissen (40) mit einer ersten Seite und einer zweiten Seite, wobei die erste Seite gegen die Abdeckung angeordnet ist und die zweite Seite gegen die zweite Seite der Stromversorgungsvorrichtung angeordnet ist, wobei die erste Befestigung und die zweite Befestigung den Brückenabschnitt, die Stromversorgungsvorrichtung und das Thermokissen gegen die Modulgehäuseabdeckung halten; und
eine Leiterplatte (46) mit einer ersten Seite und einer zweiten Seite, wobei die erste Seite der Leiterplatte gegen eine zweite Seite des Brückenabschnitts angeordnet ist und die zweite Seite der Leiterplatte gegen eine Schicht aus Vergussmasse angeordnet ist, die auf dem Bodenabschnitt des Modulgehäuses verbleibt.

15. Elektrisch isoliertes, doppelt gedämmtes elektronisches Kontrollmodul zur Verwendung in einem Elektrowerkzeuggehäuse, wobei das elektronische Kontrollmodul Folgendes umfasst:
ein Modulgehäuse (22), wobei das Modulgehäuse vier Wände aufweist, einen Bodenabschnitt, der mit den vier Wänden an einem Ende der vier Wände verbunden ist, wobei die vier Wände ein Ende gegenüber dem Bodenabschnitt aufweisen und **dadurch** eine Öffnung definieren;
eine Abdeckung, die die Öffnung des Modulgehäuses abdeckt;
eine Stromversorgungsvorrichtung (38) mit einer ersten Seite und einer zweiten Seite, wobei die zweite Seite der Stromversorgungsvorrichtung der Abdeckung gegenüber liegt, wobei die erste Seite der Stromversorgungsvorrichtung auf einer ersten Seite eines Brückenabschnitts (54) angeordnet ist, wobei der Brückenabschnitt weiter umfasst:
eine erste Wand und eine zweite Wand, um einen Behälter zu bilden, um die Stromversorgungsvorrichtung darin aufzunehmen, eine erste Säule und eine zweite Säule, wobei sich die erste Säule und die zweite Säule jeweils durch eine erste Befestigung bzw. eine zweite Befestigung mit der Abdeckung verbinden;
ein Thermokissen (40) mit einer ersten Seite und einer zweiten Seite, wobei die erste Seite gegen die Abdeckung angeordnet ist und die zweite Seite gegen das Elektrowerkzeuggehäuse angeordnet ist, wobei die erste Befestigung und die zweite Befestigung den Brückenabschnitt und die Stromversorgungsvorrichtung gegen die Modulgehäuseabdeckung halten; und
eine Leiterplatte (46) mit einer ersten Seite und einer zweiten Seite, wobei die erste Seite der Leiterplatte gegen eine zweite Seite des Brückenabschnitts angeordnet ist und die zweite Seite der Leiterplatte gegen eine Schicht aus Vergussmasse angeordnet ist, die auf dem Bodenabschnitt des Modulgehäuses verbleibt.

## Revendications

1. Module électronique adapté pour être disposé dans un logement (22) d'un outil motorisé alimenté en CA, et pour utiliser une portion du logement comme dissipateur de chaleur, le module comprenant :
un dispositif électrique (38) ayant une languette externe (42) et étant couplé une source de tension de secteur, ledit dispositif électrique fournissant une première couche d'isolation électrique entre la source de tension de secteur et la languette externe du dispositif électrique ; et
un écran thermique (40) disposé entre la languette externe et le logement, l'écran thermique fournissant une deuxième couche d'isolation électrique entre la languette externe et le logement ;
lesdites première et deuxième couches se combinant pour fournir une quantité minimale prédéterminée d'isolation électrique entre la source de tension de secteur et le logement tout en permettant audit logement de fonctionner comme un dissipateur de chaleur afin de dissiper la chaleur développée par ledit dispositif électrique.

2. Module électronique selon la revendication 1, comprenant en outre un support formant pont, ledit support formant pont comprenant en outre une première paroi et une seconde paroi pour former une prise afin d'y recevoir ledit dispositif électrique.

3. Support formant pont selon la revendication 2, dans lequel ledit support formant pont comprend en outre un premier montant et un second montant, ledit premier montant et ledit second montant étant espacés l'un de l'autre et utilisés pour arrimer ledit dispositif électrique au sein dudit module.

4. Module électronique selon la revendication 1, comprenant en outre une carte de circuit, ladite carte de circuit étant couplée fixement audit dispositif électrique.

5. Module électronique selon la revendication 4, dans lequel ledit module comprend un logement de module, et une couche de matériau d'imprégnation disposée au sein dudit logement de module pour supporter la carte de circuit sur ladite couche au sein dudit logement de module.

6. Matériau d'imprégnation selon la revendication 5, dans lequel ledit matériau d'imprégnation est placé au sein dudit logement de module pour remplir des vides dans ledit logement de module après que ledit assemblage de module électronique est totalement assemblé.

7. Outil motorisé alimenté en CA ayant un module de commande électronique disposé au sein d'un logement d'outil (22) de l'outil motorisé, le logement d'outil agissant comme un dissipateur de chaleur pour le module de commande électronique, l'outil motorisé comprenant :
une tension de secteur traversant ledit logement d'outil et se connectant au module de commande électronique qui est niché dans le logement d'outil, ledit module de commande électronique comprenant :
un dispositif électrique (38), ledit dispositif électrique se connectant à ladite tension de secteur et fournissant une première couche d'isolation électrique entre ladite tension de secteur et une languette externe (42) dudit dispositif électrique ; et
un écran thermique (40) dans lequel ledit écran thermique est disposé entre ladite languette externe et un couvercle de module de commande, ledit écran thermique fournissant une deuxième couche d'isolation électrique entre ladite languette externe et ledit couvercle et fournissant une quantité minimale prédéterminée d'isolation électrique entre ladite tension de secteur et ledit logement d'outil pour empêcher un choc électrique infligé à un utilisateur en contact avec une surface externe dudit logement d'outil, où ledit logement d'outil et ledit couvercle de module de commande agissent également comme des dissipateurs de chaleur pour dissiper la chaleur développée par ledit dispositif électrique.

8. Module de commande selon la revendication 7, comprenant en outre un mécanisme de raccordement comprenant :
un premier montant sur un premier côté dudit dispositif électrique ;
un second montant sur un second côté du dispositif électrique ;
une portion formant pont raccordant ledit premier montant et ledit second montant, lesdits montants contenant des filetages et arrimant une première vis et une seconde vis, respectivement.

9. Module de commande selon la revendication 8, dans lequel ladite portion formant pont dudit mécanisme de raccordement maintient ledit dispositif électrique et ledit écran thermique contre ledit couvercle de module de commande lorsque ladite première vis et ladite seconde vis sont serrées.

10. Ecran thermique selon la revendication 9, dans laquelle ledit écran thermique est comprimé à une épaisseur minimale de 1 mm.

11. Outil motorisé selon la revendication 7, comprenant en outre une paroi d'outil motorisé, ladite paroi d'outil motorisé comprenant en outre une surface intérieure et une surface extérieure, ladite paroi d'outil motorisé agissant comme un dissipateur de chaleur pour ledit module de commande pour la chaleur dégagée par ledit module de commande lorsque ledit module de commande est attaché à ladite surface intérieure de ladite paroi d'outil motorisé.

12. Outil motorisé selon la revendication 7, comprenant en outre une carte de circuit, ladite carte de circuit étant en contact avec ledit dispositif électrique au sein dudit module de commande.

13. Outil motorisé selon la revendication 12, comprenant en outre un matériau d'imprégnation, ledit matériau d'imprégnation fournissant une fondation pour arrimer ladite carte de circuit au sein dudit module de commande.

14. Module de commande électronique à double isolation, électriquement isolé à utiliser dans un outil motorisé, le module de commande électronique comprenant :
un logement de module (22), ledit logement de module ayant quatre parois, une portion de base raccordée auxdites quatre parois à une extrémité desdites quatre parois, lesdites quatre parois ayant une extrémité opposée à ladite portion de base, définissant ainsi une ouverture ;
un couvercle qui couvre ladite ouverture dudit logement de module ;
un dispositif électrique (38) ayant un premier côté et un second côté, ledit second côté du dispositif électrique étant tourné vers ledit couvercle, ledit premier côté de dispositif électrique étant situé sur un premier côté d'une portion formant pont (54), ladite portion formant pont comprenant en outre :
une première paroi et une seconde paroi pour former une prise pour recevoir ledit dispositif électrique, un premier montant et un second montant, ledit premier montant et ledit second montant étant chacun liés audit couvercle par une première fixation et une seconde fixation, respectivement ;
un écran thermique (40) ayant un premier côté et un second côté, ledit premier côté étant situé contre ledit couvercle et ledit second côté étant situé contre ledit second côté dudit dispositif électrique, ladite première fixation et ladite seconde fixation maintenant ladite portion formant pont, ledit dispositif électrique, et ledit écran thermique contre ledit couvercle de logement de module ; et
une carte de circuit (46) ayant un premier côté et un second côté, ledit premier côté de ladite carte de circuit étant situé contre un second côté de ladite portion formant pont, et ledit second côté de ladite carte de circuit étant situé contre une couche de matériau d'imprégnation qui repose sur ladite portion de base dudit logement de module.

15. Module de commande électronique à double isolation, électriquement isolé à utiliser dans un outil motorisé, le module de commande électronique comprenant :
un logement de module (22), ledit logement de module ayant quatre parois, une portion de base raccordée auxdites quatre parois à une extrémité desdites quatre parois, lesdites quatre parois ayant une extrémité opposée à ladite portion de base, définissant ainsi une ouverture ;
un couvercle qui couvre ladite ouverture dudit logement de module ;
un dispositif électrique (38) ayant un premier côté et un second côté, ledit second côté du dispositif électrique étant tourné vers ledit couvercle, ledit premier côté de dispositif électrique étant situé sur un premier côté d'une portion formant pont (54), ladite portion formant pont comprenant en outre :
une première paroi et une seconde paroi pour former une prise pour y recevoir ledit dispositif électrique, un premier montant et un second montant, ledit premier montant et ledit second montant étant chacun liés audit couvercle par une première fixation et une seconde fixation, respectivement ;
un écran thermique (40) ayant un premier côté et un second côté, ledit premier côté étant situé contre ledit couvercle et ledit second côté étant situé contre le logement d'outil motorisé, ladite première fixation et ladite seconde fixation maintenant ladite portion formant pont et ledit dispositif électrique contre ledit couvercle de logement de module ; et
une carte de circuit (46) ayant un premier côté et un second côté, ledit premier côté de ladite carte de circuit étant situé contre un second côté de ladite portion formant pont, et ledit second côté de ladite carte de circuit étant situé contre une couche de matériau d'imprégnation qui repose sur ladite portion de base dudit logement de module.
